Europäisches Patentamt

European Patent Office

Office européen des brevets

(19)

(11) Veröffentlichungsnummer: **0 245 627**
**A1**

(12) **EUROPÄISCHE PATENTANMELDUNG**

(21) Anmeldenummer: 87104441.8

(22) Anmeldetag: 25.03.87

(51) Int. Cl.4 **H01L 21/60** , H01L 21/31 , H01L 23/48

(30) Priorität: 12.05.86 DE 3615893

(43) Veröffentlichungstag der Anmeldung:
19.11.87 Patentblatt 87/47

(84) Benannte Vertragsstaaten:
AT BE CH DE FR GB IT LI LU NL SE

(71) Anmelder: **Siemens Aktiengesellschaft Berlin und München**
**Wittelsbacherplatz 2**
**D-8000 München 2(DE)**

(72) Erfinder: **Grewal, Virinder, Dr.**
**Karwendelstrasse 45**
**D-8017 Ebersberg(DE)**
Erfinder: **Koller, Klaus**
**Münchner Strasse 16**
**D-8033 Planegg(DE)**

(54) Verfahren zum Auffüllen von in Isolationsschichten geätzten Kontaktlöchern mit Wolfram bei der Herstellung von höchstintegrierten Halbleiterschaltungen.

(57) Beim Auffüllen von Kontaktlöchern (3) in Isolationsschichten (2) von integrierten Halbleiterschaltungen wird die aus Wolfram bestehende ganzflächig auf dem Substrat (1) abgeschiedene Metallschicht (4, 5) mit einer Hilfsschicht (6) aus organischem Material bedeckt, die organische Hilfsschicht (6) anisotrop bis zur Wolframoberfläche (5) geätzt, dann die Wolframschicht (4, 5) selektiv bis zur Isolationsschicht (2) zurückgeätzt und schließlich die Restschicht (6a) des organischen Materials, die sich im Kontaktlochbereich (3) auf den Wolfram-Plugs (5a) befinden, selektiv entfernt. Auf diese Weise gelingt es, Kontaktlöcher (und auch via holes) im Durchmesser von 1 µm und darunter zuverlässig mit Wolfram zu füllen, welche bei nachfolgenden Metallisierungsprozessen eine guten Kantenbedeckung gewährleisten. Die Kontakte sind mit hohen Stromdichten belastbar. Das Verfahren wird verwendet zur Herstellung von Mehrlagenverdrahtungen von höchstintegrierten Schaltungen.

FIG 2

## Verfahren zum Auffüllen von in Isolationsschichten geätzten Kontaktlöchern mit Wolfram bei der Herstellung von höchstintegrierten Halbleiterschaltungen.

Die Erfindung betrifft ein Verfahren zum Auffüllen von in Isolationsschichten geätzten Kontaktlöchern mit metallisch leitenden Materialien, wie sie insbesondere zur Herstellung von höchstingegrierten Halbleiterschaltungen zur Ausbildung von elektrischen Leitbahnen auf strukturierten Halbleitersubstraten erforderlich sind, bei dem als metallisch leitendes Material Wolfram aus der Gasphase zunächst ganzflächig auf dem mit der Isolationsschichtstruktur versehenen Halbleitersubstrat abgeschieden wird und dann durch Rückätzen der Wolframschicht in den Kontaktlöchern Plomben (sogenannte plugs) aus Wolfram aufgebaut werden, bevor die nächste Leitbahnebene erzeugt wird.

Bei der fortschreitenden Miniaturisierung von Halbleiterbauelementen treten bereits Strukturen im Bereich von 1 μm und darunter auf. Um die sehr kleinen aktiven Bereiche auf dem Halbleitersubstrat elektrisch ansteuern zu können, müssen diese mit metallischen Leitbahnen verbunden werden. Damit dieser Kontakt nur an definierten Stellen stattfindet, ist die Leitbahn durch eine Isolationsschicht, zum Beispiel aus $SiO_2$ bestehend, vom Halbleitersubstrat getrennt. Die Verbindung zu den aktiven Bereichen des Halbleitersubstrates findet über Kontaktlöcher statt, die in die Isolationsschicht eingeätzt werden.

Analoge Verhältnisse herrschen auch bei höchstintegrier ten Bauelementen, wobei zwei und mehr Leitbahnebenen für die elektrische Versorgung der sehr dicht gepackten aktiven Bereiche notwendig sind. Auch in diesem Fall muß ein elektrischer Kontakt durch sehr kleine Löcher (via holes) zwischen den verschiedenen Leitbahnebenen hergestellt werden.

Da aufgrund von schaltungstechnischen Überlegungen (zum Beispiel parasitäre Kapazitäten) die Isolationsschicht eine Mindestdicke von 0,7 bis 1,5 μm besitzen muß, treten bei den Kontaktlöchern bzw. via holes Tiefen/Durchmesser-Verhältnisse von größer 1 auf. Bei diesen sehr kleinen und tiefen Kontaktlöchern nimmt die Schichtdicke der Leitbahnen an den Flanken des Kontaktloches sehr stark ab (55 bis 80 Prozent Abnahme), wenn das Leitbahnmaterial, zum Beispiel Aluminiumlegierungen : Aluminium-Silizium (1 %), wie bisher üblich durch Kathodenzerstäubung (Sputtern) aufgebracht wird. Da die Leitbahnen mit extrem hohen Stromdichten belastet sind (zum Beispiel 1 x 10⁶ A/cm²) bewirkt eine jede Querschnittsverengung einen lokalen Temperaturanstieg, der an den Grenzflächen zwischen den verschiedenen Materialien im Kontakt einen unerwünschten Materialtransport (Diffusion, Reaktion) beschleunigt. Dies kann auch bis zum Durchbrennen einer Leitbahn führen.

Bereits für die Beschichtung von Kontaktlöchern mit einem Tiefen/Durchmesser-Verhältnis von kleiner 1 müssen mehrere Maßnahmen getroffen werden, um an den vertikalen Flanken noch 25 bis 60 Prozent der horizontalen Schichtdicke zu erreichen.

In jüngster Zeit werden auch CVD ( = chemical vapor d eposition)-Verfahren, die sich durch eine sehr gute Kantenbedeckung auszeichnen, zum Auffüllen von Kontakten eingesetzt. Dabei wird, wie zum Beispiel aus einem Aufsatz von D. L. Brors et. al. aus dem Solid State Technology, April 1984, Seiten 313 bis 314, bekannt ist, ganzflächig auf der Isolationsschicht einschließlich der Kontaktlöcher unter Verwendung von Wolfram eine Metallisierungsschicht abgeschieden. Aufgrund der guten Kantenbedeckung des CVD-Verfahrens wächst die Schicht im Kontaktloch von allen Seiten etwa gleich schnell und füllt somit das Kontaktloch auf. Dieser Zustand ist bei einer Schichtdicke (gemessen auf horizontaler Struktur), die etwas mehr als der Hälfte des Kontaktlochdurchmessers entspricht, eingetreten. Ätzt man nun die Metallschicht wieder ganzflächig ab, so kann erreicht werden, daß das Metall von der Isolierschicht vollständig entfernt ist, während das Kontaktloch noch mit Metall gefüllt bleibt. Durch dieses Verfahren kann im besten Falle eine konforme Abscheidung von Wolfram im Kontaktloch erzielt werden.

Aufgabe der Erfindung ist es, dieses Verfahren dahingehend zu verbessern, daß

1. ein lunkerfreies Auffüllen der Kontaktlöcher gewährleistet ist,

2. die Isolationsschichtoberfläche frei von Wolframresten ist,

3. keine Flankenabscheidungen (spacer-Bildung) entstehen und

4. eine möglichst hohe Ätzselektivität zur Isolationsschicht vorhanden ist.

Die erfindungsgemäße Aufgabe wird durch ein Verfahren der eingangs genannten Art gelöst, welches durch den Ablauf folgender Verfahrensschritte gekennzeichnet ist:

a) nach der ganzflächigen Wolframbeschichtung wird ganzflächig eine Hilfsschicht aus organischem Material aufgebracht.

b) die organische Hilfsschicht wird soweit anisotrop zurückgeätzt, bis die Wolframoberfläche mit Ausnahme der Kontaktlochfläche wieder freigelegt ist,

c) die Wolframschicht wird selektiv bis zur darunterliegenden Isolationsschicht zurückgeätzt und

d) die Reste der organischen Hilfsschicht in den Kontaktlöchern werden entfernt.

Weitere Ausgestaltungen der Erfindung ergeben sich aus den Unteransprüchen.

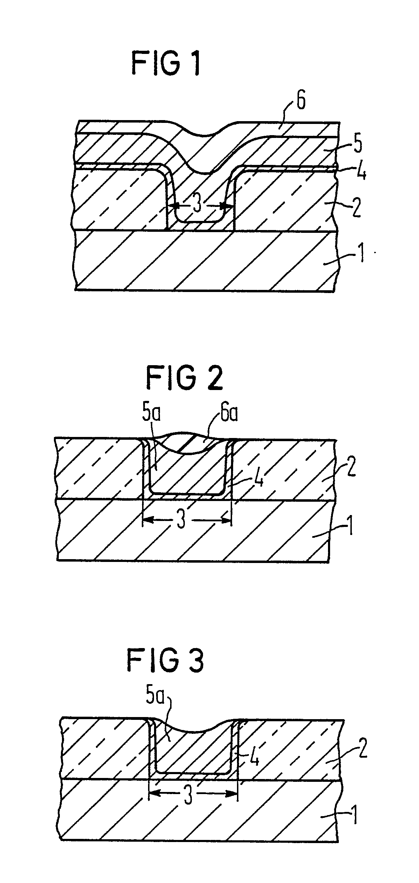

Im folgenden wird anhand eines Ausführungsbeispiels und der Figuren 1 bis 3, welche im Schnittbild die erfindungswesentlichen Verfahrensschritte darstellen, das Verfahren der Kontaktlochauffüllung mit Wolfram unter Verwendung eines verbesserten Rückätzprozesses noch näher beschrieben. Dabei gelten in allen Figuren für gleiche Teile gleiche Bezugszeichen.

Figur 1: Auf das mit dem Bezugszeichen 1 gekennzeichnete Substrat, zum Beispiel einer Siliziumoberfläche als zu kontaktierende Oberfläche. wird eine als Isolationsschicht dienende Bor-Phosphor-Silikatglasschicht 2 aufgebracht, in die das Kontaktloch 3 mit einem Durchmesser von ca. 0,8 $\mu$m eingeätzt worden ist. Auf diese Anordnung 1. 2, 3 wird nach kurzem Überätzen in Flußsäure, um die Haftfestigkeit der Wolframschicht bzw. Wolfram/Silizium-Schicht zu erhöhen, nun ganzflächig eine Doppelschicht 4. 5. bestehend aus einer 1000 Å dicken Wolfram-Silizium-Legierung (1:2,5) und einer 8000 Å dicken reinen Wolframschicht 5 durch thermische Zersetzung von Wolframhexafluorid mit Wasserstoff als Reaktionsgas bei 450°C in einem Kaltwandreaktor bei niedrigem Druck aufgebracht. Die Zwischenschicht 4 aus Wolfram/Silizium dient als Diffusionsbarriere bei späteren Temperaturschritten. Die Anordnung 1, 2, 3. 4, 5 wird dann durch Aufschleudern und Aushärten mit einer Polyimid-oder Photolackschicht 6 versehen.

Figur 2: Nun wird die organische Hilfsschicht 6 durch Plasmaätzen in einer sauerstoffhaltigen Atmosphäre von der Wolframoberfläche 5 soweit wieder entfernt. daß nur im Bereich des Kontaktloches 3 Inseln 6a aus organischem Material stehenbleiben. Diese Inseln 6a dienen im nächsten Ätzschritt. der im Plasma in einer Sauerstoff und Schwefelhexafluorid enthaltenden Atmosphäre zur Entfernung der Wolframoberflächenschicht 5 und der darunterliegenden Wolfram/Silizium/Legierungsschicht 4 durchgeführt wird, als Plasmaätzmasken für die darunterliegenden plugs 5a. Der Ätzprozeß verläuft selektiv in einer Magnetron-Ätzanlage bis die Bor-Phosphor-Silikatglasschichtoberfläche 2 freigelegt ist. Der Endpunkt wird automatisch unter Verwendung der WF$_6$-Linie (578 nm) festgestellt.

Figur 3: Jetzt werden noch die Reste 6a der organischen Hilfsschicht 6 entfernt und dann darauf im nächsten Verfahrensschritt eine weitere Metallisierungsebene, zum Beispiel bestehend aus Aluminium/Silizium durch Kathodenzerstäubung abgeschieden (in der Figur 3 nicht dargestellt).

Mit der beschriebenen Prozeßfolge lassen sich sehr zuverlässige Kontakte sowohl zwischen den Leitbahnebenen und dem Halbleitersubstrat als auch zwischen den verschiedenen Leitbahnebenen herstellen. Die hohe Zuverlässigkeit kommt dadurch zustande, daß die Schichten auf ein quasi ebenes Substrat aufgebracht werden. Da keine Schichtdickenabnahme im Kontaktloch bzw. via hole auftritt,.ist die effektive Stromdichte an diesen Stellen geringer, so daß der Kontakt eine höhere Lebensdauer be sitzt.

## Ansprüche

1. Verfahren zum Auffüllen von in Isolationsschichten (2) geätzten Kontaktlöchern (3) mit metallisch leitenden Materialien (4, 5), wie sie insbesondere zur Herstellung von höchstintegrierten Halbleiterschaltungen zur Ausbildung von elektrischen Leitbahnen auf strukturierten Halbleitersubstraten (1) erforderlich sind, bei dem als metallisch leitendes Material (4. 5) Wolfram aus der Gasphase ganzflächig auf den mit der Isolationsschichtstruktur (2) versehenem Halbleitersubstrat (1) abgeschieden wird und dann durch Rückätzen der Wolframschicht (4. 5) in den Kontaktlöchern (3) Plomben (plugs 5a) aus Wolfram aufgebaut werden. bevor die nächste Leitbahnebene erzeugt wird. dadurch gekennzeichnet, daß

a) nach der ganzflächigen Wolfram-Beschichtung (4. 5) ganzflächig eine Hilfsschicht (6) aus organischem Material aufgebracht wird,

b) die organische Hilfsschicht (6) soweit anisotrop zurückgeätzt wird, bis die Wolframoberfläche (4) mit Ausnahme der Kontaktlochfläche (3) wieder freigelegt ist.

c) die Wolframschicht (4. 5) selektiv bis zur darunterliegenden Isolationsschicht (2) zurückgeätzt wird, und

d) die Reste (6a) der organischen Hilfsschicht (6) in den Kontaktlöchern (3) entfernt werden.

2. Verfahren nach Anspruch 1, dadurch gekennzeichnet, daß die die Kontaktlöcher (3) enthaltende Isolationsschicht (2) aus SiO$_2$ besteht. welche vorzugsweise mit Bor und/oder Phosphor dotiert ist.

3. Verfahren nach Anspruch 1 oder 2. dadurch gekennzeichnet, daß eine aus Photolack oder Polyimid bestehende organische Hilfsschicht (6) verwendet wird.

4. Verfahren nach einem der Ansprüche 1 bis 3. **dadurch gekennzeichnet,** daß der anisotrope Ätzprozeß nach Verfahrensschritt b) durch Plasmaätzen mit Sauerstoff als Ätzgas erfolgt.

5. Verfahren nach einem der Ansprüche 1 bis 4, **dadurch gekennzeichnet,** daß der anisotrope Ätzprozeß nach Verfahrensschritt c) durch Plasmaätzen mit einem Fluor-Ionen und Sauerstoff enthaltenden Ätzgas erfolgt.

6. Verfahren nach Anspruch 5, **dadurch gekennzeichnet,** daß ein Gasgemisch aus Schwefelhexafluorid ($SF_6$) und Sauerstoff verwendet wird.

7. Verfahren nach einem der Ansprüche 1 bis 6. **dadurch gekennzeichnet,** daß die Entfernung der Hilfsschicht-Rest (6a) nach Verfahrensschritt d) durch Plasmaätzen mit Sauerstoff als Ätzgas erfolgt.

8. Verfahren nach einem der Ansprüche 1 bis 7. **dadurch gekennzeichnet,** daß vor der ganzflächigen Wolframabscheidung (4. 5) nach Verfahrensschritt a) eine naßchemische Überätzung der Kontaktlochfläche (3) in Flußsäure durchgeführt wird.

9. Verfahren nach einem der Ansprüche 1 bis 8. **dadurch gekennzeichnet,** daß vor der ganzflächigen Wolframabscheidung (5) nach Verfahrensschritt a) eine aus Wolfram-Silizium ($WSi_x$ mit x größer 2,2) bestehende Legierung (4) als Barriereschicht abgeschieden wird.

10. Verfahren nach Anspruch 9, **dadurch gekennzeichnet,** daß das Schichtdickenverhältnis der Wolfram-Silizium-Legierung zur Wolframschicht auf 1:8 eingestellt wird.

11. Verfahren nach Anspruch 9 und 10. **dadurch gekennzeichnet,** daß die Schichtdicke der Wolfram-Silizium-Schicht (4) auf 1000 Å eingestellt wird.

12. Verfahren nach einem der Ansprüche 1 bis 11. **dadurch gekennzeichnet,** daß für die anisotropen Ätzprozesse eine Magnetron-Ätzanlage verwendet wird.

## FIG 1

## FIG 2

## FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl 4) |
|---|---|---|---|
| X | WO-A-8 502 377 (STORAGE TECHNOLOGY PARTNERS) * Seite 8, Zeile 22 - Seite 10, Zeile 9 * | 1,3,4, 7 | H 01 L 21/60 H 01 L 21/31 H 01 L 23/48 |
| | --- | | |
| X | EP-A-0 177 105 (N.V. PHILIPS' GLOEILAMPENFABRIEKEN) * Ansprüche 2,4,6 * | 1 | |
| A | * Ansprüche 12,25 * | 2,9 | |
| | --- | | |
| X | APPLIED PHYSICS LETTERS, Band 39, Nr. 9, 1. November 1981, Seiten 742-743, American Institute of Physics, New York, US; J.N. RANDALL et al.: "High-resolution pattern definition in tungsten" * Zusammenfassung * | 5,6 | RECHERCHIERTE SACHGEBIETE (Int. Cl. 4) H 01 L |
| | ---      -/- | | |

Der vorliegende Recherchenbericht wurde für alle Patentansprüche erstellt

| Recherchenort | Abschlußdatum der Recherche | Prüfer |
|---|---|---|
| DEN HAAG | 15-08-1987 | PHEASANT N.J. |

Europäisches
Patentamt

**EUROPÄISCHER RECHERCHENBERICHT**

Nummer der Anmeldung

EP 87 10 4441

Seite 2

| | **EINSCHLÄGIGE DOKUMENTE** | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
| A | JOURNAL OF VACUUM SCIENCE & TECHNOLOGY B, Band 3, Nr. 6, November/Dezember 1985, Seiten 1657-1663, American Vacuum Society, New York, US; R.A. HAKEN: "Application of the self-aligned titanium silicide process to very large-scale integrated NMOS and CMOS technologies"<br>* Seite 1657, Spalte 2, Zeilen 26-30 * | 8 | |
| | ----- | | |
| | | | **RECHERCHIERTE SACHGEBIETE (Int. Cl.4)** |

Der vorliegende Recherchenbericht wurde für alle Patentansprüche erstellt

| Recherchenort | Abschlußdatum der Recherche | Prüfer |
|---|---|---|
| DEN HAAG | 15-08-1987 | PHEASANT N.J. |